(19)

**Europäisches Patentamt**

**European Patent Office**

**Office européen des brevets**

(11) **EP 1 347 580 A2**

(12) **EUROPEAN PATENT APPLICATION**

(43) Date of publication:
**24.09.2003 Bulletin 2003/39**

(51) Int Cl.[7]: **H03M 13/29**, H03M 13/27

(21) Application number: **03012167.7**

(22) Date of filing: **12.10.1999**

(84) Designated Contracting States:
**AT BE CH CY DE DK ES FI FR GB GR IE IT LI LU MC NL PT SE**

(30) Priority: **13.10.1998 US 104040 P**
**14.12.1998 US 112318 P**

(62) Document number(s) of the earlier application(s) in accordance with Art. 76 EPC:
**99953182.5 / 1 119 915**

(71) Applicant: **INTERDIGITAL TECHNOLOGY CORPORATION**
**Wilmington, DE 19801 (US)**

(72) Inventor: **Shin, Sung-Hyuk**
**Fort Lee, NJ 07024 (US)**

(74) Representative: **Frohwitter, Bernhard, Dipl.-Ing.**
**Patent- und Rechtsanwälte,**
**Possartstrasse 20**
**81679 München (DE)**

Remarks:
This application was filed on 03 - 06 - 2003 as a divisional application to the application mentioned under INID code 62.

(54) **Hybrid interleaver for turbo codes**

(57)    The present invention provides a method of data transmission wherein at least one data sequence of size N ordered bits are processed by a turbo code encoder with a hybrid interleaver.

*FIG. 6*

EP 1 347 580 A2

**Description**

**BACKGROUND OF THE INVENTION**

**Field of the Invention**

The present invention relates generally to processes that create time diversity in systems with high processing gain. More specifically, the invention relates to a system and method of turbo code interleaving mapping where the number of tail bits required to flush the storage registers of each constituent encoder to an all-zero state are reduced.

**Description of the Prior Art**

In many types of data communication systems, whether voice or non-voice, signal diversity or redundancy when transmitting information is shown to improve performance without compromising other aspects of the data transmission system. Two techniques that add time diversity are known as interleaving and forward error-correcting (FEC) coding.

The process of interleaving is where the input data sequence is permuted or reordered into another sequence. For example:

$$(0\,1\,2\,3\,4\,5\,6\,7) \xleftarrow{\;I_N\;} (3\,0\,6\,7\,1\,5\,2\,4)$$

where the mathematical operator $I_N$ *[J]* transposes the original position of each bit or symbol of a finite input sequence to a new position *J* by operation of the interleaver $I_N$. This reordering process that achieves time diversity is called interleaving and can be performed in a number of ways. Two methods of typical interleaving are known as block and random interleaving.

At the transmission destination, the signal is again reordered, putting the data sequence back in the original order. The inverse process is called deinterleaving.

The most recent advance in coding techniques which exhibit the best performance are turbo codes. A variety of turbo code interleaver designs exist and require less complexity when decoding. The three most popular are: 1) block interleavers; 2) pseudo-random interleavers; and 3) S-random interleavers.

The best performing interleavers are the S-random interleavers. The S-random interleavers exploit the property of not mapping neighbor positions within a certain sequence length, to neighbor positions exhibiting the same length. This makes the sequence length as large as possible. All interleaver designs require a specific set of rules setting forth input sequence size and permutation.

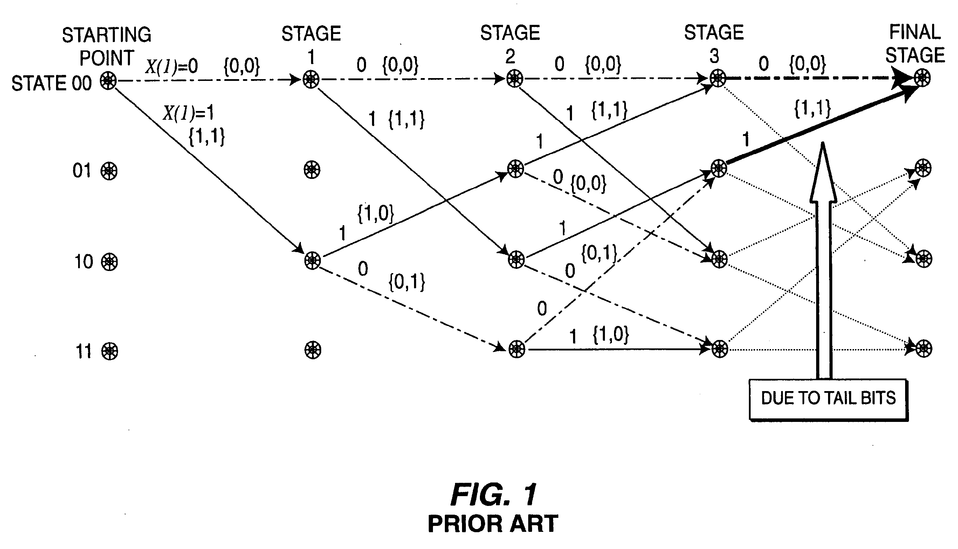

In conjunction with interleaving, FEC coding improves performance for signals that are coherently demodulated. FEC coding adds additional redundancy in the original data sequence. In communication systems that communicate over a spread spectrum air interface, redundancy is already present in the shared spectral transmission channel. A FEC encoder is a finite-state machine that relies upon nodes or states and delay registers. The predetermined transitions between the registers define a path from which a given data input may produce an output. A common way to illustrate the encoding and decoding technique for the convolutionally encoded data is the use of a trellis diagram which is known to those familiar with this art. A trellis diagram is an infinite replication of a state machine diagram and is shown in **Figure 1**.

The decoding is typically performed using a maximum likelihood algorithm which relies upon the trellis structure and the path state or metric for each level and each selected node or state. Any code word of a convolutional code corresponds to the symbols along a path in the trellis diagram. At each state and at each level of the trellis an add-compare-select operation is performed to select the best path and state. The trellis is assembled over many received symbols. After a predefined number of symbols have been accumulated, the determination finds the trellis path with the smallest error. The final decision on all bits in the trellis is made via the encoders by forcing the encoder to return to an initial all-zero state. This is achieved by inserting zero tail bits at the end of the finite bit stream after encoding. This process is referred to as "tailing off."

A process known as "chaining back" is performed starting at the last node, tracing the decision path back from the last decision to the first. This method of decoding determines which symbol was originally sent. The trellis structure introduces redundancy and accumulates past history.

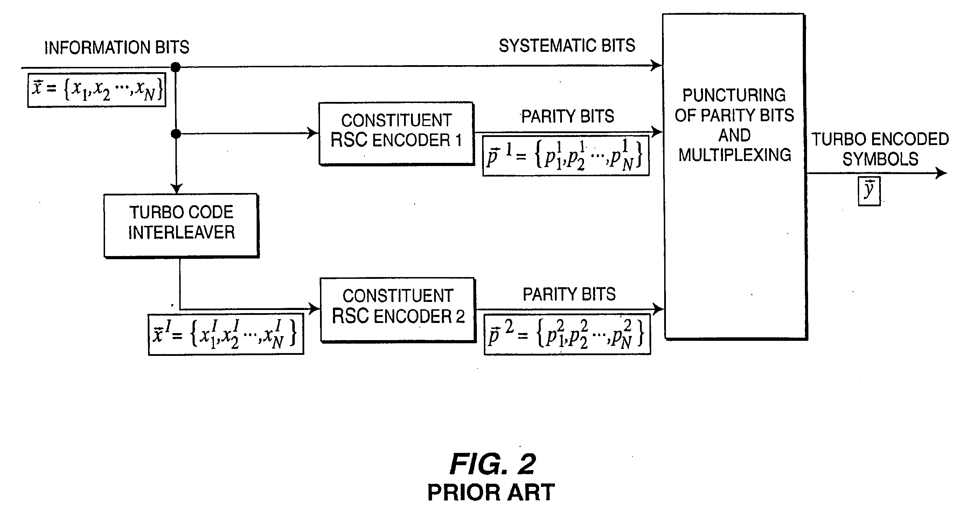

A prior art turbo encoder is shown in **Figure 2**. The encoder comprises first and second systematic recursive convolutional code (RCS) encoders coupled in parallel with a turbo code interleaver coupled prior to the second recursive convolutional encoder. The two recursive convolutional codes used in each encoder are known as the constituent codes. The first encoder reorders the input information bits $\vec{x}_N$ in their original order while the second encoder reorders the input bits as permuted by the turbo code interleaver $\vec{x}^I_N$. The input information sequence $\vec{x}_N$ is always transmitted through a channel. In dependence upon the data transmission rate, the outputs from both encoders may be "punctured" before transmission $\vec{y}_N$. Puncturing is a process where alternate outputs of the lower taps (first and second encoders $\vec{p}1_N, \vec{p}2_N$) are deleted from the output. This process establishes a code rate.

The turbo code interleaver is a scrambler defined by a permutation of the sequence length with no repetitions. A complete sequence is input into the interleaver and output in a predefined order.

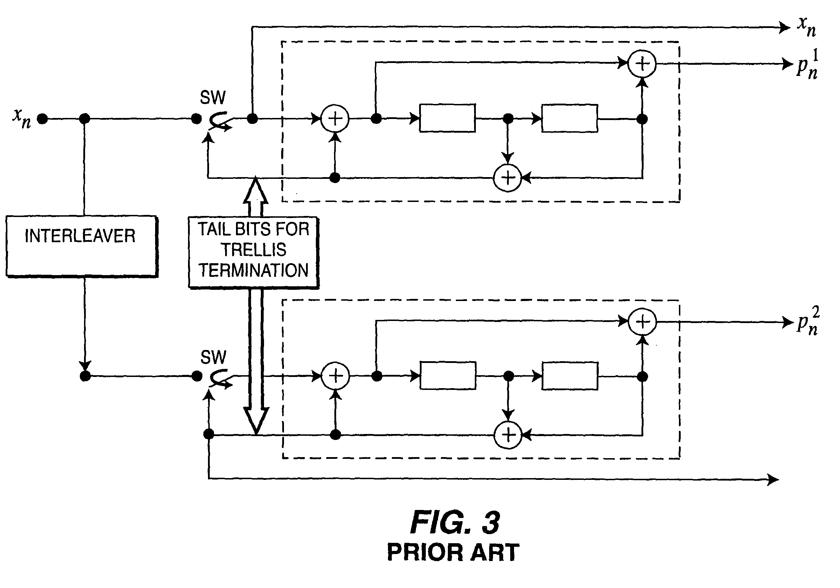

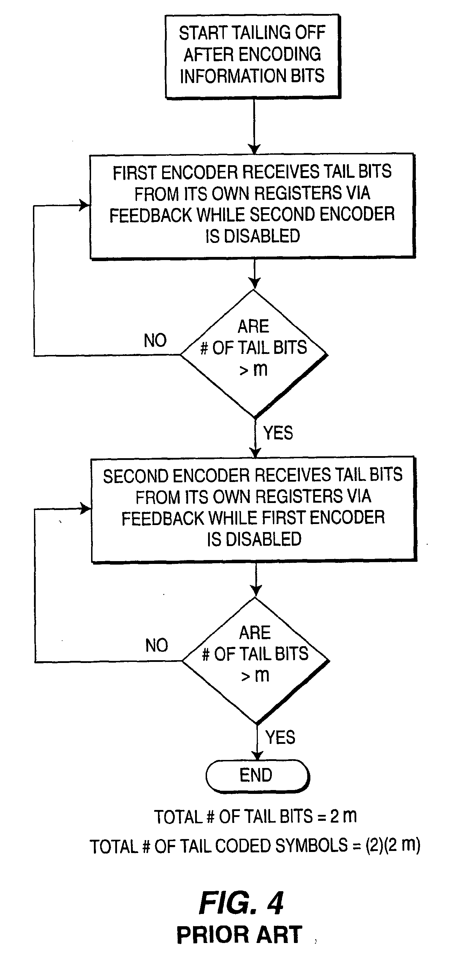

A prior art tailing off process is shown and described in **Figures 3** and **4**. The tail bits for each encoder are obtained from register feedback from each respective encoder as shown in **Figure 3**. Since the register contents of each constituent encoder are different at the beginning of the tailing off operation, each encoder must be flushed separately. As described in **Figure 4**, each encoder (in **Figure 3**) is flushed independently and exclusive of each other after the information bits have been encoded. Each encoder derives and receives its own tail bits. Therefore, if m equals the number of states or register memory of an encoder, m tail bits are required for one encoder and 2m are required for both encoders.

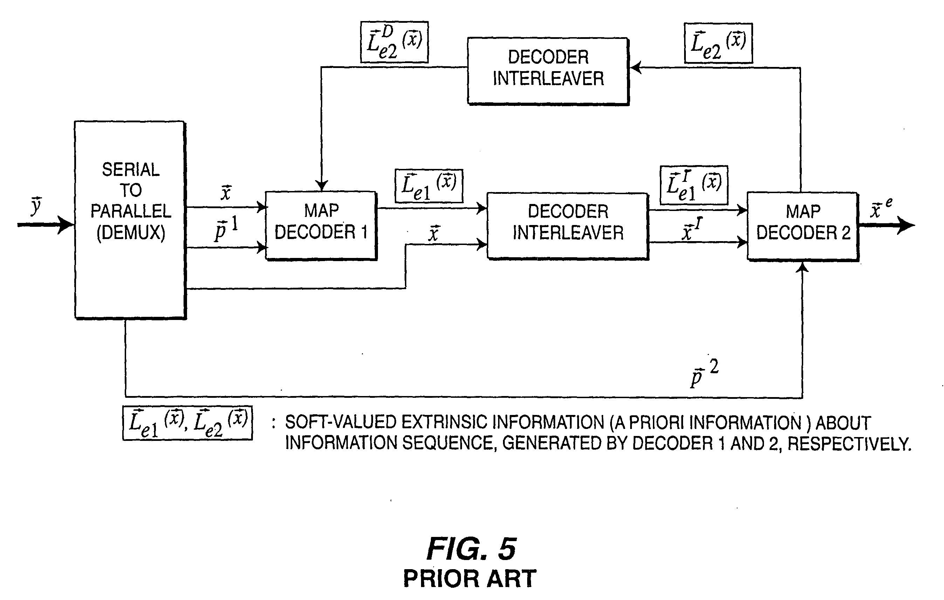

A prior art turbo code decoder is shown in **Figure 5.** On receiving the demodulated soft value signal $\vec{y}_N$, the soft-decision information for the systematic (information) and parity bits $\vec{p}1_N$ from the first constituent encoder are input to a first constituent decoder. The first constituent decoder generates updated, soft-decision likelihood values $\vec{L}_{e1}(\vec{x}_N)$ for the information bits that are input along with the information bits to a decoder interleaver. The input to a second constituent decoder includes the interleaved soft-valued sequences $\vec{x}^I_N$ and $\vec{L}^I_{e1}(\vec{x}_N)$ and the parity bits $\vec{p}2_N$ from the second constituent encoder. The output of the second decoder improves on the soft-decision likelihood values derived from the output from the first constituent decoder and is fed back to the first constituent decoder after reordering in accordance with the turbo decoder interleaver as an iterative process. The output $\vec{x}^e$ from the second constituent decoder is obtained after the decoding operation is completed.

As discussed above, the use of a turbo code interleaver requires that coding be performed on a finite sequence length. To encode such a finite information sequence, it is necessary for both constituent RSC encoders in the turbo encoder to start and end in an all zero-state for trellis termination. However, due to the presence of the turbo interleaver, it is difficult to simultaneously force the two constituent encoders to terminate in an all zero-state with the same trellis bits. Most prior art turbo encoders have their information sequences terminated with a plurality of tail bits. Tail bits are considered a nuisance and as overhead of the turbo encoded sequence.

Accordingly, there exists a need for a turbo code interleaver that does not require a plurality of tail bits to force each constituent encoder to an all-zero state.

## SUMMARY OF THE INVENTION

The present invention relates to a turbo code hybrid interleaver having recursive systematic constituent encoders. The system and process encodes a finite frame of bits without requiring a plurality of tail bits to flush the registers of each encoder to an all-zero state. The hybrid interleaver reduces the turbo code overhead by using the same tail bits for both constituent encoders improving the performance of the best turbo interleaver.

Accordingly, it is an object of the present invention to provide a system and method of interleaving that does not require a plurality tail bits to be part of the encoding process.

It is a further object of the invention to eliminate the unnecessary overhead in the turbo code encoding sequence limiting the number of tail bits that terminate the encoding process to an all-zero state with a single m-bit tail where m is the number of storage registers in each constituent encoder.

Other objects and advantages of the system and the method will become apparent to those skilled in the art after reading the detailed description of the preferred embodiment.

## BRIEF DESCRIPTION OF THE DRAWINGS

**Figure 1** is a prior art trellis diagram for a 4 state RSC encoder.
**Figure 2** is a system diagram of a prior art, turbo code encoder.
**Figure 3** is a system diagram of a prior art, four state encoder showing tailing off.
**Figure 4** is a flowchart of a prior art method of tailing off.
**Figure 5** is a system diagram of a prior art, turbo code decoder.
**Figure 6** is a system diagram of a turbo code encoder with a hybrid interleaver employing the system and method of the present invention.
**Figure 7** is a flowchart of the interleaver method embodying the present invention.

**Figure 8** is a 16 frame size interleaving sequence produced by the present invention for a 4 state turbo code encoder with S equal to 2 and L equal to 4.

**Figure 9** is the mapping of the interleaving sequence of **Figure 8**.

**Figure 10** is the 16 frame size interleaving sequence of **Figure 8** verified.

**Figure 11** is a flowchart of the tailing off method embodying the present invention.

**Figure 12** is a flowchart of an alternative embodiment.

## DETAILED DESCRIPTION OF THE PREFERRED EMBODIMENTS

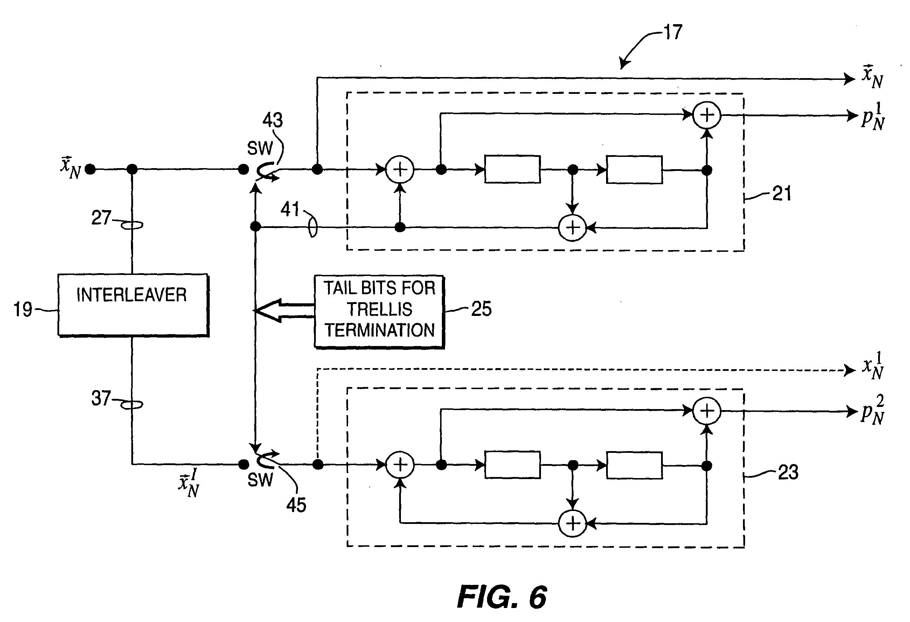

A turbo code encoder **17** with a hybrid interleaver **19** taught in accordance with the present invention as shown in **Figure 6** terminates the first **21** and second **23** RCS constituent encoders to an all-zero state using a single tailing off bit operation **25**. The present invention **17** exploits the cyclic property of each constituent encoder **21**, **23** in conjunction with keeping the performance of the best turbo interleavers. The turbo code encoder **17** with hybrid interleaver **19** reduces additional tail bit overhead necessary for trellis termination of each constituent encoder **21**, **23**.

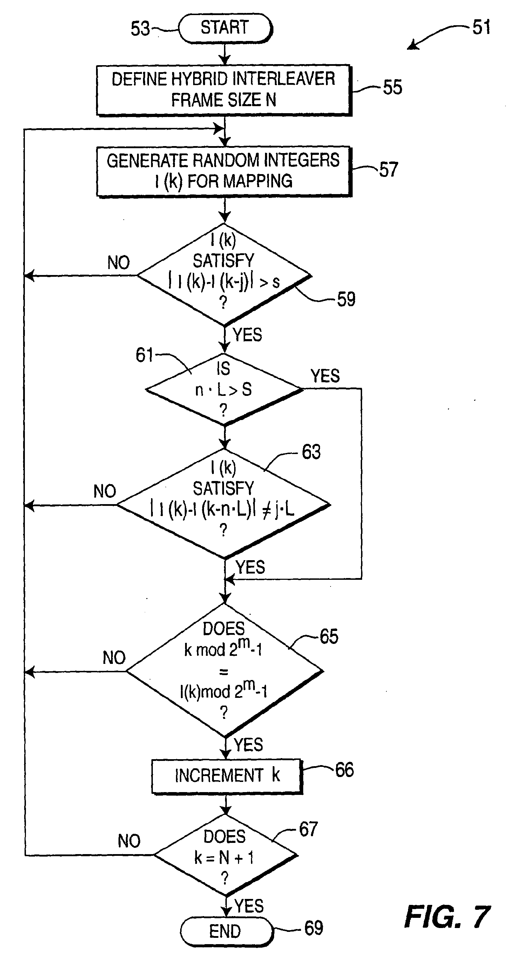

**Figures 6** and **7**, describe the system and process of the hybrid turbo code interleaver **19**. The process **51** begins (**step 53**) by receiving a sequence of input data **27** for encoding. The encoding sequence frame size N is chosen (**step 55**). The state size and puncturing rate (code rate) are independent of the hybrid interleaver **19**. The hybrid interleaver **19** generates the random integers $I(k)$ for permutation (**step 57**).

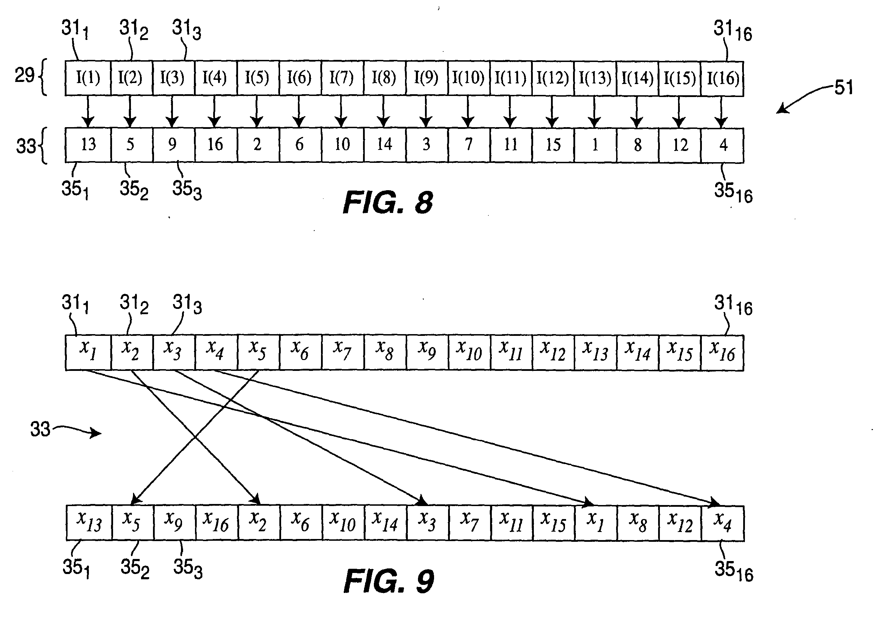

As shown in **Figures 8** and **9**, the generation of the random integer sequence is performed bit by bit for each frame **29** position $31_{1-N}$. The generation of a random integer (**step 57**) denoted as $I(k)$ is:

$$1 \leq I(k) \leq N \qquad \text{Equation (1)}$$

where k = 1,2,...,$N$ for each mapped **33** position $35_{1-N}$ in the interleaver sequence. The current selection, $I(k)$ must meet conditions A (**step 59**), B (**step 63**) and C (**step 65**) as follows.

$$\textit{Condition A:} |I(k) - I(k-j)| > S \qquad \text{Equation (2)}$$

where

$$0 < j \leq S \qquad \text{Equation (3)}$$

and

$$k-j \geq 0. \qquad \text{Equation (4)}$$

*Condition* A **Equation (2)** represents the properties of S-random interleavers. S is an arbitrary value.

$$\textit{Condition B:} |I(k)-I(k-n \cdot L)| \neq j \cdot L \qquad \text{Equation (5)}$$

(**step 63**) where n and j are positive integers subject to:

$$k-n \cdot L \geq 0; \qquad \text{Equation (6)}$$

and

$$n \cdot L \leq S \qquad \text{Equation (7)}$$

(**step 61**) $L$ is determined by the constituent encoder used in the turbo code encoder. As an example, $L$=7 is used in an eight state turbo encoder.

$$\text{Condition C: } k \bmod 2^m - 1 = I(k) \bmod 2^m - 1 \, \forall k \qquad\qquad \text{Equation (9)}$$

(**step 65**) where m is the size of memory in the constituent encoder. For 4 and 8 state encoders, m equals 2 and 3 respectively. The above steps are repeated until all of the integers, $I(k)$ for k=1,2,...,$N$, (**step 66**) for the hybrid interleaver **19** are selected (**step 67**) and output (**step 69**).

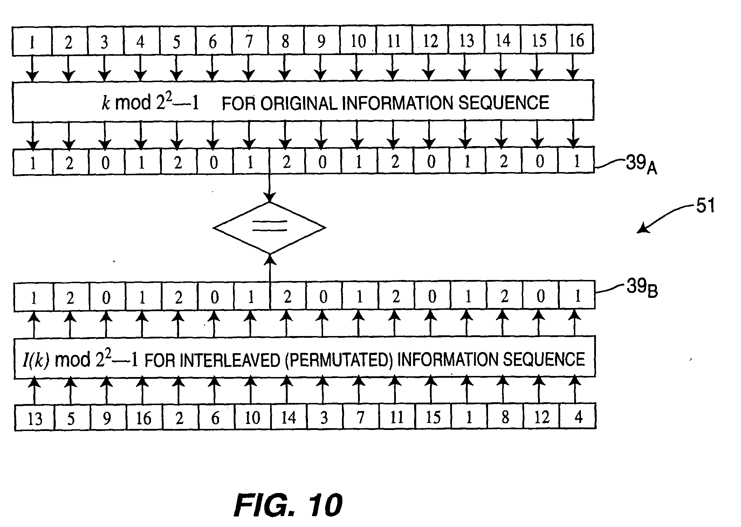

An example of the above system and method is shown in **Figures 8**, **9** and **10**. A sequence frame size of 16 using a 4 state turbo code encoder **17** with hybrid interleaver **19** with S equal to 2 and *L* equal to 4 is shown permuted in accordance with the teachings of the invention. The hybrid interleaver **19** satisfies *Conditions A* and B. The hybrid interleaver **19** output **37** is verified in **Figure 10** using *Condition C* such that after dividing the index of an input **27** information sequence by $2^m$-1, the resulting remainder sequence **39A** is equal to the corresponding remainder sequence **39B** due to the interleaving mapping index **33**. Once the turbo code hybrid interleaver **19** is specified **51**, the information bits **27** are permuted according the hybrid interleaver **19** in order for the second **23** constituent encoder to receive the output **37.**

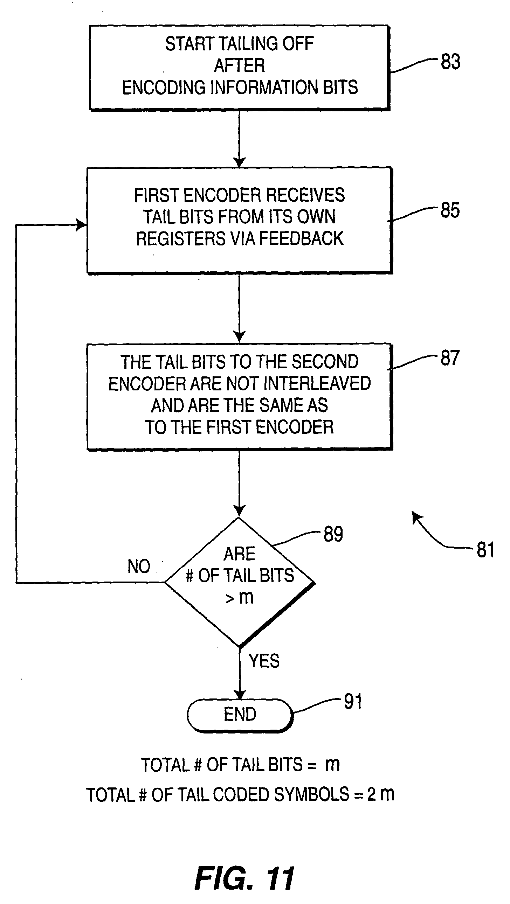

The process of the present invention that terminates the trellis using the same tail bits for the first **21** and second **23** constituent encoders is shown and described in **Figures 6** and **11**. As described above, the information bits are encoded by both encoders. The first **21** constituent encoder operates on the information bits **27** in their original order. The second **23** constituent encoder operates on the information bits **27** as permuted **37** according to the hybrid interleaver **19**. The output from the first **21** and second **23** constituent encoders are punctured and multiplexed producing an output (see **Figure 2**).

The trellis termination process **81** using the same tail bits for both constituent encoders starts (**step 83**) with acknowledging that all of the information bits have been encoded by the first **21** and second **23** constituent encoders. At this time in the encoding process, the register contents of both encoders are the same. The first **21** and second **23** encoders switch inputs from the original information **27** and permuted **37** bit streams to feedback **41** from the first **21** encoder. The puncturing of the first **21** encoder output $\vec{p}1_N$ and the second **23** output $\vec{p}2_N$ with the information output $\vec{x}_N$ for the tailing off process is the same as during the encoding **21**, **23** of the information bits **27**, **37**. After both switches **43**, **45** transition, the first **21** encoder receives tail bits from its own register via the feedback **41** (**step 85**). The tail bits to the second **23** encoder have not been interleaved by the hybrid interleaver **19** and are the same tail bits **41** for trellis termination as in the first **21** encoder (**step 87**).

For a M state encoder, $\log_2$ M tail bits are required to flush all of the registers in the first **21** and second **23** encoders to an all-zero state. With L = $\log_2$M, **Table 1** shows the required number of tail bits and the total number of tail coded symbols for a 4 and 8 state encoder.

TABLE 1

|  |  | *L* | Total coded bits at tail part (prior art) | Total coded bits at tail part (present invention) |
|---|---|---|---|---|
| 8-state encoder | ½ rate Turbo code | 3 | 2 X 6 = 12 | 6 |
|  | 1/3 rate Turbo code | 3 | 2 X 9 = 18 | 9 |
| 4-state encoder | ½ rate Turbo code | 2 | 2 X 4 = 8 | 4 |
|  | 1/3 rate Turbo code | 2 | 2 X 6 = 12 | 6 |

For a 1/2 rate and 1/3 rate turbo code encoder with four (4) state constituent encoders, the present invention **17** eliminates 4 and 6 tail bits, respectively. For a 1/2 rate and 1/3 rate turbo code encoder with eight (8) state constituent encoders, the present invention **17** eliminates 6 and 9 tail bits, respectively, as compared to and required by the prior art.

The turbo code encoder with the hybrid interleaver yields better performance than prior art S-random interleavers since the rules stated in *Condition B* avoids worst case low weight distribution of the turbo codes while *Condition A* retains the best characteristics. Since the hybrid interleaver **19** leads to the same trellis state sequences for both the first **21** and second **23** constituent decoders at the beginning of the tail part, the use of a single m-bit tail sequence to flush both the first **21** and second **23** encoders to an all-zero state is acceptable. The extrinsic information $\vec{L}^I_{e1}$ including tail bits generated from the first constituent decoder are passed on to the second constituent decoder which increases to overall performance (see **Figure 5**).

As an example, if the original information sequence is

$$\vec{x}_N = \{1011010001110101\}.$$

The permuted information sequence according to the hybrid interleaver **19** is

$$\vec{x}_N^I = \{0001011110101011\}.$$

The information sequence is encoded by the first **21** and second **23** constituent encoders. The first **21** constituent encoder operates on the input $\vec{x}$ in its original order, while the second **23** constituent encoder operates on the permuted $\vec{x}^I$ interleaver **19** output.

The trellis state sequence obtained from the first **21** encoder is {2333100002100233310}. The trellis state sequence obtained from the second **23** encoder is {000233333100233310}.

As shown above, the last two states (four bits) from each trellis state sequence are the same due to the hybrid interleaver **19**. This allows the first **21** and the second **23** constituent encoders to receive the same tail bits leading to the reduced overhead of the turbo coding process.

Condition C leads the trellis state of two constituent encoders to be the same after encoding information bits. This allows the same tail bits for both constituent encoders, resulting in the reduction of turbo-code overhead due to tail bits. In addition, using the same tail bits is desirable for an interative decoder as previously explained in which the interleaver design was based on a S-random interleaver. While the present invention improves turbo-code performance, its memory requirement is the same as for the S-random interleaver with the memory storage requirement proportional to the interleaver size.

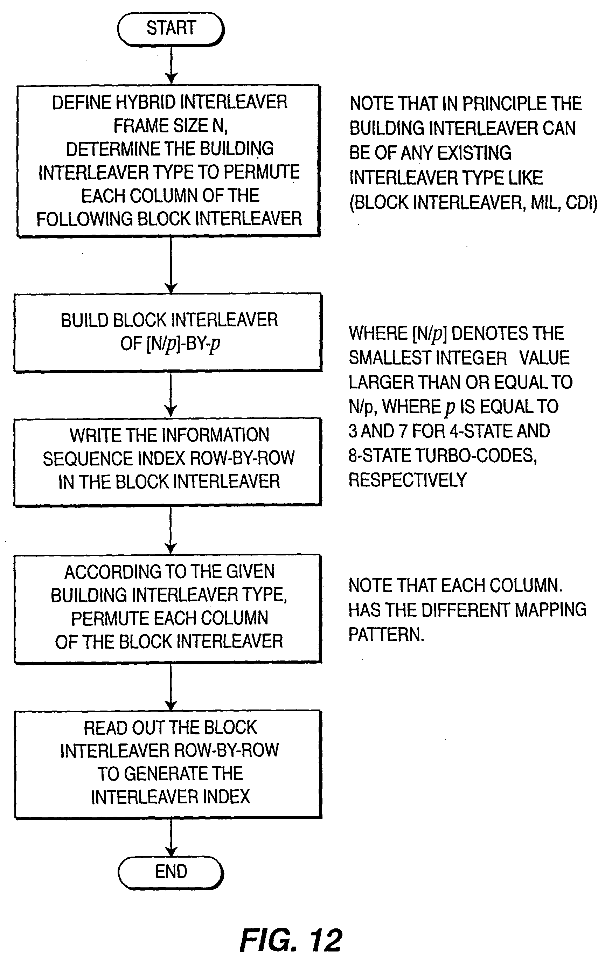

An alternative embodiment is described in **Figure 12**.

Let D denote the information sequence of binary bits with block size $N$ such that:

$$D = \{d_1, d_2, ..., d_N\} \ where \ d_k = \pm 1 \qquad \text{Equation (10)}$$

Given a M-state turbo-coder where M is equal to 4 or 8, we can partition the information sequence, D, into p-disjoint subsets, S, where p=M-1 as follows:

$$So = \{d_k|, k \bmod p = 0\} \qquad \textbf{Equation (11)}$$

$$S_1 = \{d_k|, k \bmod p = 1\} \qquad \textbf{Equation (12)}$$

$$\cdot$$
$$\cdot$$
$$\cdot$$

$$S_{p-1} = \{d_k|, k \bmod p = p - 1\}$$

$$\textbf{Equation (13)}$$

where p is set to be 3 and 7 for 4-state and 8-state turbo codes, respectively. The above partition method is similar to the above coset partitioning. The value of p for each state Turbo-code is specified.

Each subset has the block size of $\lfloor N/p \rfloor$ where $\lfloor N/p \rfloor$ denotes the smallest integer value larger than or equal to $N/p$. Each subset is permuted by the use of any interleaver mapping. Then we combine all the individual subsets in order to obtain the entire interleaver output, denoted as $I$, as follows:

```
Count=0;

for k=1: Block _size of subset

      for i= 1: P

            if i=p

                I(count)=  S₀(k)

            else

                I(count)=  Sᵢ(k)

            end if

            count = count + 1

            if count =N

                  exit

          end

      end

end
```

where $S_i(k)$ is the $k^{th}$ interleaved output bit of the subset $S_i$ and $S_0(k)$ is the $k^{th}$ interleaved output bit of the subset $S_0$. The above mentioned procedures including partition and combining subsets can be re-illustrated by using a block interleaver with $\lfloor N/p \rfloor$ rows and p columns as follows:

1) The information bits are stored row-wise in the block interleaver as follows:

Write ⟹

| $d_1$ | $d_2$ | $d_3$ | ..... | $d_p$ |
|---|---|---|---|---|
| $d_{p+1}$ | $d_{p+2}$ | $d_{p+3}$ | ..... | $d_{2p}$ |
| $d_{2p+1}$ | $d_{2p+2}$ | $d_{2p+3}$ | ..... | $d_{3p}$ |
| $d_{3p+1}$ | $d_{3p+2}$ | $d_{3p+3}$ | ..... | $d_{4p}$ |
| : | : | : | ..... | : |
| $d_{N/p+1}$ | $d_{N/p+2}$ | $d_{N/p+3}$ | ..... | $d_{N/p+p}$ |

⇑ $S_1$     ⇑ $S_2$     ⇑ $S_3$     ⇑ $S_0$

2) Permute the bits within each column block according to the given interleaver type, which can be, in principle, one of any candidate interleavers. For example, applying conditions A and B to each column block; condition C is not necessary under these circumstances.

3) Read out the matrix row-by-row in order as shown below to drive the second constituent, whose input is the interleaved output sequence, to the same state as without interleaving the original information sequence.

Read ⟹

| $d_{N/p}+1$ | $d_{N/p+2}$ | $d_{N/p+3}$ | .... | $d_{N/p+p}$ |
|---|---|---|---|---|
| $d_{3p+1}$ | $d_{3p+2}$ | $d_{3p+3}$ | .... | $d_{4p}$ |
| $d_{2p+1}$ | $d_{2p+2}$ | $d_{2p+3}$ | .... | $d_{3p}$ |
| : | : | : | .... | : |
| $d_{p+1}$ | $d_{p+2}$ | $d_{p+3}$ | .... | $d_{2p}$ |
| $d_1$ | $d_2$ | $d_3$ | .... | $d_p$ |

⇑ $S_1$     ⇑ $S_2$     ⇑ $S_3$     ⇑ $S_0$

While the present invention has been described in terms of the preferred embodiment, other variations which are in the scope of the invention as outlined in the claims below will be apparent to those skilled in the art.

## Claims

1. A method of data transmission wherein at least one data sequence of size N ordered bits are processed by a turbo code encoder (17) with a hybrid interleaver (19), comprising the steps of:

   a. encoding said input bit set using a first encoder (21) having a multi-state register to provide a first output;

b. selectively reordering the input bit set using a hybrid interleaver (19) to provide an S-random reordered input bit set, whereby said interleaver reorders said integers $I(k)$ such that once reordered, the value for $|I(k) - I(k-nL)|$ is not evenly divisible by L, where $L = 2^m - 1$, n is a positive integer defined as $k - nL \geq 0$ and $nL \leq S$, and S is an arbitrary predetermined value; and

c. encoding said reordered input bit set using a second encoder (23) having a multi-state register to provide a second output; and

d. switching input to said first encoder (21) and said second encoder (23) using a switch, whereby a first input and a feedback from said first output is switched at the first encoder (21) and a second input and feedback from said first output is switched at said second encoder (23).

2. The method according to claim 1, further comprising the steps of:

generating a set of tail bits for each said input bit set; and
applying said tail bit set to reset the registers of both said first and second encoders.

3. The method according to claim 1 wherein said selective reordering comprises the steps of;

a) receiving a plurality of N information bits where N is a positive integer;
b) defining the hybrid interleaver frame size $N$;
c) generating random integers $I(k)$ for k from 1 to N that satisfy the conditions:

1) $|I(k) - I(k-j)| > S$, where $S$ is a predetermined arbitrary value and j is a positive integer defined as $0 < j \leq S$ and $k - j \geq 0$;
2) $nL \leq S$, where $L$ equals number of encoder register states minus 1, and $n$ is a positive integer defined by $k - nL \geq 0$, where if not true, proceed to step 4;
3) $|I(k) - I(k-nL)| \neq jL$ where if not true, repeat steps 1-3, otherwise proceed to step 4;
4) For each random integer $I(k)$, $k \bmod 2^m - 1 = I(k) \bmod 2^m - 1$, where $2^m$ is the number of register states of one of said encoders, if not true, repeat steps 1-4; and

d) outputting permuted interleaver data sequence for encoding.

4. The method according to claim 2 further comprising the steps of:

a) acknowledging that encoding by said first and second encoder is complete;
b) switching inputs to said first and second encoder from an information bit stream and a permuted bit stream respectively to common feedback from said first constituent encoder last stage; and
c) incrementing the number of tail bits received from said feedback until said number of tail bits are greater than the number of registers used in said first constituent encoder, if not, repeat steps b - c.

5. The method of claim 1, whereby $d_k$ is an input bit of said set of N bits and $d_k = \pm 1$, said selective reordering further comprising the steps of:

arranging said input bit set for an M state turbo code encoder into $p$ disjoint subsets $S_i$ of size b, where $p = M-1$, $i$ is an integer from 0 to $p-1$, and b is the smallest integer value larger than or equal to $N/p$, where $S_i = \{d_k|, k \bmod p = i\}$;
combining subsets $S_i$, to form a block of b rows and $p$ columns where $k$ is an integer from 1 to $b$ such that each element of a subset is in the same column;
reordering the subset elements within each column; and
outputting said rows after said column reordering to produce an interleaver reordered input bit set.

6. A method of data transmission wherein at least one data sequence of ordered bits $d_k = \pm 1$ is processed by an M state turbo code encoder (17) with a hybrid interleaver (19), the method comprising the steps of:

a) receiving the data sequence by the interleaver;
b) defining the hybrid interleaver frame size $N$;
c) writing said data sequence bits row-wise into $p$ disjoint subsets $S_i$ of size b, where $p = M-1$, i is an integer from 0 to $p-1$, and $b$ is the smallest integer value larger than or equal to $N/p$, where $S_i = \{d_k|, k \bmod p = i\}$ forming a block of $b$ rows and $p$ columns where $k$ is an integer from 1 to $b$ such that each element of a subset is in the same column;

e) permuting the subset bits within each column block according to a sequence of random integers $I(k)$ for $k$ from 1 to $b$ that satisfy the conditions:

1) $|I(k) - I(k-j)| > S$, where $S$ is a predetermined arbitrary value and $j$ is a positive integer defined as $0<j\leq S$ and $k-j \geq 0$;

2) $nL \leq S$, where L equals number of encoder register states minus 1, and $n$ is a positive integer defined by $k - nL \geq 0$; and

3) $|I(k) - I(k-nL)| \neq jL$ where if not true, repeat step (e) ; and

f) reading out an interleaver output sequence from said block row-by-row.

**FIG. 1**
**PRIOR ART**

STARTING POINT

STATE 00

STAGE 1

STAGE 2

STAGE 3

FINAL STAGE

$X(1)=0$   {0,0}

$X(1)=1$   {1,1}

0   {0,0}

1   {1,1}

0   {0,0}

1   {1,1}

0   {0,0}

1   {1,1}

0   {0,0}

{1,1}

01

10

11

1

0   {0,0}

{1,0}

1

0   {0,1}

0

1   {1,0}

1

DUE TO TAIL BITS

EP 1 347 580 A2

11

INFORMATION BITS

$\bar{x} = \{x_1, x_2 \cdots, x_N\}$

SYSTEMATIC BITS

CONSTITUENT RSC ENCODER 1

PARITY BITS

$\vec{p}^{\ 1} = \{p_1^1, p_2^1 \cdots, p_N^1\}$

TURBO CODE INTERLEAVER

$\bar{x}^I = \{x_1^I, x_2^I \cdots, x_N^I\}$

CONSTITUENT RSC ENCODER 2

PARITY BITS

$\vec{p}^{\ 2} = \{p_1^2, p_2^2 \cdots, p_N^2\}$

PUNCTURING OF PARITY BITS AND MULTIPLEXING

TURBO ENCODED SYMBOLS

$\bar{y}$

*FIG. 2*
**PRIOR ART**

EP 1 347 580 A2

EP 1 347 580 A2

$x_n$

$p_n^1$

SW

$x_n$

INTERLEAVER

TAIL BITS FOR
TRELLIS
TERMINATION

$p_n^2$

SW

**FIG. 3**
**PRIOR ART**

START TAILING OFF
AFTER ENCODING
INFORMATION BITS

FIRST ENCODER RECEIVES TAIL BITS
FROM ITS OWN REGISTERS VIA
FEEDBACK WHILE SECOND ENCODER
IS DISABLED

NO — ARE
# OF TAIL BITS
> m

YES

SECOND ENCODER RECEIVES TAIL BITS
FROM ITS OWN REGISTERS VIA
FEEDBACK WHILE FIRST ENCODER
IS DISABLED

NO — ARE
# OF TAIL BITS
> m

YES

END

TOTAL # OF TAIL BITS = 2 m

TOTAL # OF TAIL CODED SYMBOLS = (2)(2 m)

# *FIG. 4*
## **PRIOR ART**

EP 1 347 580 A2

$\vec{L}_{e1}(\vec{x}), \vec{L}_{e2}(\vec{x})$ : SOFT-VALUED EXTRINSIC INFORMATION (A PRIORI INFORMATION ) ABOUT INFORMATION SEQUENCE, GENERATED BY DECODER 1 AND 2, RESPECTIVELY.

**FIG. 5**
**PRIOR ART**

FIG. 6

53 — ( START )

51

DEFINE HYBRID INTERLEAVER
FRAME SIZE N — 55

GENERATE RANDOM INTEGERS
I (k) FOR MAPPING — 57

I (k)
SATISFY
$|I(k)-I(k-j)| > s$
?  — 59

NO

YES

61 — IS
$n \cdot L > S$
?

YES

I (k) — 63
SATISFY
$|I(k)-I(k-n \cdot L)| \neq j \cdot L$
?

NO

YES

DOES
$k \bmod 2^m-1$
=
$I(k) \bmod 2^m-1$
?  — 65

NO

YES

INCREMENT k — 66

DOES
$k = N + 1$
?  — 67

NO

YES

( END ) — 69

*FIG. 7*

EP 1 347 580 A2

$31_1$ $31_2$ $31_3$ $31_{16}$

$29\{$ | I(1) | I(2) | I(3) | I(4) | I(5) | I(6) | I(7) | I(8) | I(9) | I(10) | I(11) | I(12) | I(13) | I(14) | I(15) | I(16) |

51

$33\{$ | 13 | 5 | 9 | 16 | 2 | 6 | 10 | 14 | 3 | 7 | 11 | 15 | 1 | 8 | 12 | 4 |

$35_1$ $35_2$ $35_3$ $35_{16}$

**FIG. 8**

$31_1$ $31_2$ $31_3$ $31_{16}$

| $x_1$ | $x_2$ | $x_3$ | $x_4$ | $x_5$ | $x_6$ | $x_7$ | $x_8$ | $x_9$ | $x_{10}$ | $x_{11}$ | $x_{12}$ | $x_{13}$ | $x_{14}$ | $x_{15}$ | $x_{16}$ |

33

| $x_{13}$ | $x_5$ | $x_9$ | $x_{16}$ | $x_2$ | $x_6$ | $x_{10}$ | $x_{14}$ | $x_3$ | $x_7$ | $x_{11}$ | $x_{15}$ | $x_1$ | $x_8$ | $x_{12}$ | $x_4$ |

$35_1$ $35_2$ $35_3$ $35_{16}$

**FIG. 9**

| 1 | 2 | 3 | 4 | 5 | 6 | 7 | 8 | 9 | 10 | 11 | 12 | 13 | 14 | 15 | 16 |

$k \bmod 2^2 - 1$    FOR ORIGINAL INFORMATION SEQUENCE

| 1 | 2 | 0 | 1 | 2 | 0 | 1 | 2 | 0 | 1 | 2 | 0 | 1 | 2 | 0 | 1 | ~39$_A$

~51

$=$

| 1 | 2 | 0 | 1 | 2 | 0 | 1 | 2 | 0 | 1 | 2 | 0 | 1 | 2 | 0 | 1 | ~39$_B$

$I(k) \bmod 2^2 - 1$ FOR INTERLEAVED (PERMUTATED) INFORMATION SEQUENCE

| 13 | 5 | 9 | 16 | 2 | 6 | 10 | 14 | 3 | 7 | 11 | 15 | 1 | 8 | 12 | 4 |

## FIG. 10

```
                    ┌─────────────────────────┐
                    │    START TAILING OFF     │
                    │          AFTER           │── 83
                    │ ENCODING INFORMATION BITS│
                    └─────────────────────────┘
                                 │
                                 ▼
                    ┌─────────────────────────┐
                    │   FIRST ENCODER RECEIVES │
              ┌────►│   TAIL BITS FROM ITS OWN │── 85
              │     │   REGISTERS VIA FEEDBACK │
              │     └─────────────────────────┘
              │                  │
              │                  ▼
              │     ┌─────────────────────────┐
              │     │ THE TAIL BITS TO THE SECOND│
              │     │ ENCODER ARE NOT INTERLEAVED│── 87
              │     │    AND ARE THE SAME AS     │
              │     │     TO THE FIRST ENCODER   │
              │     └─────────────────────────┘
              │                  │
              │                  ▼          89
              │                ◇◇◇◇◇                          81
              │              ◇◇     ◇◇                        ↖
              │      NO    ◇   ARE    ◇
              └──────────◇  # OF TAIL BITS ◇
                          ◇     > m     ◇
                            ◇◇      ◇◇
                              ◇◇◇◇◇
                                 │
                                YES
                                 │
                                 ▼
                            ╭─────────╮
                            │   END   │── 91
                            ╰─────────╯
```

TOTAL # OF TAIL BITS = m

TOTAL # OF TAIL CODED SYMBOLS = 2 m

## FIG. 11

START

DEFINE HYBRID INTERLEAVER
FRAME SIZE N,
DETERMINE THE BUILDING
INTERLEAVER TYPE TO PERMUTE
EACH COLUMN OF THE
FOLLOWING BLOCK INTERLEAVER

NOTE THAT IN PRINCIPLE THE
BUILDING INTERLEAVER CAN
BE OF ANY EXISTING
INTERLEAVER TYPE LIKE
(BLOCK INTERLEAVER, MIL, CDI)

BUILD BLOCK INTERLEAVER
OF [N/$p$]-BY-$p$

WHERE [N/$p$] DENOTES THE
SMALLEST INTEGER VALUE
LARGER THAN OR EQUAL TO
N/p, WHERE $p$ IS EQUAL TO
3 AND 7 FOR 4-STATE AND
8-STATE TURBO-CODES,
RESPECTIVELY

WRITE THE INFORMATION
SEQUENCE INDEX ROW-BY-ROW
IN THE BLOCK INTERLEAVER

ACCORDING TO THE GIVEN
BUILDING INTERLEAVER TYPE,
PERMUTE EACH COLUMN
OF THE BLOCK INTERLEAVER

NOTE THAT EACH COLUMN.
HAS THE DIFFERENT MAPPING
PATTERN.

READ OUT THE BLOCK
INTERLEAVER ROW-BY-ROW
TO GENERATE THE
INTERLEAVER INDEX

END

## FIG. 12